# EUROPÄISCHE PATENTANMELDUNG

(11) **EP 1 783 885 A2**
(43) Veröffentlichungstag der Anmeldung: **09.05.2007**
(21) Anmeldenummer: 06022572.9
(22) Anmeldetag: 28.10.2006
(51) Int. Cl.: H02M 1/08

(54) **Treiberschaltungsanordnung zur Ansteuerung von leistungselektronischen Schaltungen**

(30) Priorität: 05.11.2005 DE 102005052800
(71) Anmelder: Semikron Elektronik GmbH & Co. KG Patentabteilung, 90431 Nürnberg (DE)
(72) Erfinder: Schreiber, Dejan, 90408 Nürnberg (DE)

(57) **Zusammenfassung**

Die Erfindung beschreibt eine Treiberschaltungsanordnung in Master - Slave Konfiguration zur Ansteuerung von leistungselektronischen Schaltungen. Der Master weist einen Eingang für ein Ansteuersignal von einer übergeordneten Ansteuerung und ein erstes Trennglied zur Potentialtrennung zur übergeordneten Ansteuerung auf. Ebenso eine Ausgangstufe mit zugehöriger Hilfsspannungsversorgung zur Ansteuerung eines zugeordneten Leistungshalbleiterbauelements, eine Mehrzahl von Überwachungsfunktionen und weiterhin ein weiteres Trennglied, wobei dieses weitere Trennglied zwischen dem ersten Trennglied und der Ausgangsstufe geschaltet ist. Der Slave weist ein Trennglied verbunden mit einer Ausgangstufe mit zugehöriger Hilfsspannungsversorgung zur Ansteuerung eines zugeordneten Leistungshalbleiterbauelements auf. In einer ersten seriellen Schaltung ist das Trennglied eines ersten Slave mit einem Ausgang des weiteren Trennglieds des Masters verbunden und der Eingang des Trennglieds eines weiteren Slaves ist mit dem Ausgang des Trenngliedes des vorgeschalteten Slaves verbunden. Alternativ ist in einer zweiten parallelen Schaltung der Eingang des Trennglieds jedes Slaves direkt mit dem Ausgang des ersten Trennglieds des Master verbunden.

## Beschreibung

Die Erfindung beschreibt eine Treiberschaltungsanordnung zur Ansteuerung von leistungselektronischen Schaltungen beispielhaft angeordnet in Leistungshalbleitermodulen mit steuerbaren Leistungshalbleiterbauelementen. Einen Ausgangspunkt der Erfindung bilden Treiberschaltungsanordnungen, wie sie beispielhaft aus der DE 102 05 832 A1 und der DE 10 2004 004 621 A1 bekannt sind.

Die DE 102 05 832 A1 offenbart eine Schaltungsanordnung zur Ansteuerung einer Mehrzahl von Leistungshalbleitermodulen, wobei jedes Leistungshalbleitermodul jeweils eine eigene Treiberschaltungsanordnung aufweist. Gemäß dieser Druckschrift werden die einzelnen Treiberschaltungsanordnungen mittels einer Fehler erkennenden oder sogar Fehler korrigierenden Verbindung seriell miteinander Verbunden. Somit ist gewährleistet, dass der Ausfall einzelner Leistungshalbleitermodule mit jeweils zugehöriger Treiberschaltungsanordnung nicht zum Ausfall der gesamten Schaltungsanordnung führt. Hierbei weist jede einzelne Treiberschaltungsanordnung die gleiche Funktionalität, auch im Hinblick auf Überwachungs- und Diagnosefunktionen, auf. Das gesamte System ist einfach skalierbar, um weitere Leistungshalbleitermodule mit zugeordneten Treiberschaltungsanordnungen, erweiterbar um an höhere Leistungen angepasst zu werden.

Die DE 10 2004 004 621 A1 offenbart einen Stromrichter, wobei die Treiberschaltungsanordnungen der einzelnen Leistungshalbleitermodule, die den Stromrichter bilden, mittels eine optischen Backplane miteinander verbunden sind. Diese gewährleistet, dass eine galvanische Trennung der einzelnen Treiberschaltungsanordnung sicher gewährleistet ist. Besonders bevorzugt sind derartige optische Backplanes allerdings für besonders hohe Schaltfrequenzen.

Der Erfindung liegt die Aufgabe zugrunde eine Treiberschaltungsanordnung zur Ansteuerung von leistungselektronischen Schaltungen, ausgebildet als Einzelschaltung beispielhaft in Form einzelner Leistungshalbleitermodulen mit steuerbaren Leistungshalbleiterbauelementen, vorzustellen, wobei diese Treiberschaltungsanordnung skalierbar mit der Anzahl der Einzelschaltungen ausgebildet ist, der schaltungstechnische Aufwand im Vergleich zum Stand der Technik reduziert ist und ein technischer Defekt einer Einzelschaltung nicht zum Defekt der anderen Einzelschaltungen führt.

Die Aufgabe wird erfindungsgemäß gelöst, durch die Maßnahmen der Merkmale des Anspruchs 1. Bevorzugte Ausführungsformen sind in den Unteransprüchen beschrieben.

Der erfinderische Gedanke geht davon aus ein skalierbares System zu schaffen, wobei die Erweiterung zu höheren Leistungen einfach und mit ausschließlich der notwendigen Funktionalität erfolgt. Skalierbare Systeme sind dahingehend vorteilhaft, dass das Basissystem für eine definierte Leistung dimensioniert ist und bei höheren Leistungsanforderungen das Basissystem annährend beliebig erweitert werden kann. Im Bereich der Leistungshalbleitermodul wird dies durch parallel schalten von bekannten Einzelmodulen erreicht. Hierbei ist aus Sicht der Ansteuerung zu beachten, dass die Zeitverzögerung beim Einschalten der einzelnen Leistungshalbleitermodule möglichst klein bleibt, um den Strom gleichzeitig und gleichmäßig auf alle Leistungshalbleitermodule zu verteilen. Den jeweiligen Leistungshalbleitermodulen werden hierbei jeweils vollständige Treiberschaltungsanordnung zugeordnet.

Die erfindungsgemäße Treiberschaltungsanordnung ist als Master - Slave Konfiguration ausgebildet. Sie weist einen Master auf, der einen "vollwertiger" Treiber darstellt, wie er in seiner Grundkonfiguration aus dem Stand der Technik bekannt ist, und bei Bedarf eine Mehrzahl von Slaves, die einen reduzierten Funktionsumfang im Vergleich zum Master aufweisen.

Der Master weist mindestens einen Eingang für ein Ansteuersignal von einer übergeordneten Ansteuerung auf, sowie weiterhin ein erstes Trennglied zur Potentialtrennung des Eingangs der übergeordneten Ansteuerung von der internen Schaltung. Ebenso weist der Master mindestens eine Ausgangstufe mit zugehöriger Hilfsspannungsversorgung zur Ansteuerung mindestens eines zugeordneten Leistungshalbleiterbauelements oder Leistungshalbleitermoduls auf. Eine Mehrzahl von Überwachungsfunktionen gemäß dem Stand der Technik sind ebenfalls Bestandteil. Zusätzlich weist der Master noch mindestens ein weiteres Trennglied auf, wobei dieses weitere Trennglied zwischen dem ersten Trennglied und der Ausgangsstufe geschaltet ist.

Die jeweiligen Slaves weisen ein Trennglied verbunden mit einer Ausgangstufe mit zugehöriger Hilfsspannungsversorgung zur Ansteuerung mindestens eines zugeordneten Leistungshalbleiterbauelements auf.

Eine erste erfindungsgemäße, serielle, Master-Slave Schaltung verbindet den Eingang des Trennglieds eines ersten Slaves mit einem Ausgang des weiteren Trennglieds des Masters. Der Eingang jedes weiteren Slaves ist mit dem Ausgang des Trenngliedes des vorgeschalteten Slaves verbunden.

Eine zweite erfindungemäße, parallele, Master-Slave Schaltung verbindet den Eingang des Trennglieds jedes Slaves direkt mit dem Ausgang des ersten Trennglieds des Masters.

Ein besonderer Vorteil der Erfindung ist, dass beispielhafte eine Zerstörung durch Fehlfunktion eines Leistungshalbleitermoduls nicht derart auf die anderen Leistungshalbleitermodule rückwirkt, dass diese auch zerstört werden.

Die erst genannte Lösung der gestellten Aufgabe mit der seriellen Anordnung weist den weiteren Vorteil auf, dass für den Master und alle Slaves die gleiche Zeitverzögerung für das Schalten aller Leistungshalbleitermodule sehr genau gegeben ist.

Die erfinderische Lösung wird an Hand der Ausführungsbeispiele der Fig. 1 bis 4 weiter erläutert.

Fig. 1 zeigt eine Treiberschaltungsanordnung für eine Leistungshalbleiterbauelement oder ein Leistungshalbleitermodul nach dem Stand der Technik.

Fig. 2 zeigt eine Schaltungsanordnung mit einer Ansteuerung und einer Mehrzahl von einzelnen Treiberschaltungsanordnungen mit jeweils zugeordnetem Leistungshalbleitermodul nach dem Stand der Technik.

Fig. 3 zeigt eine erste Ausgestaltung der erfindungsgemäßen Treiberschaltungsanordnung.

Fig. 4 zeigt eine zweite Ausgestaltung der erfindungsgemäßen Treiberschaltungsanordnung.

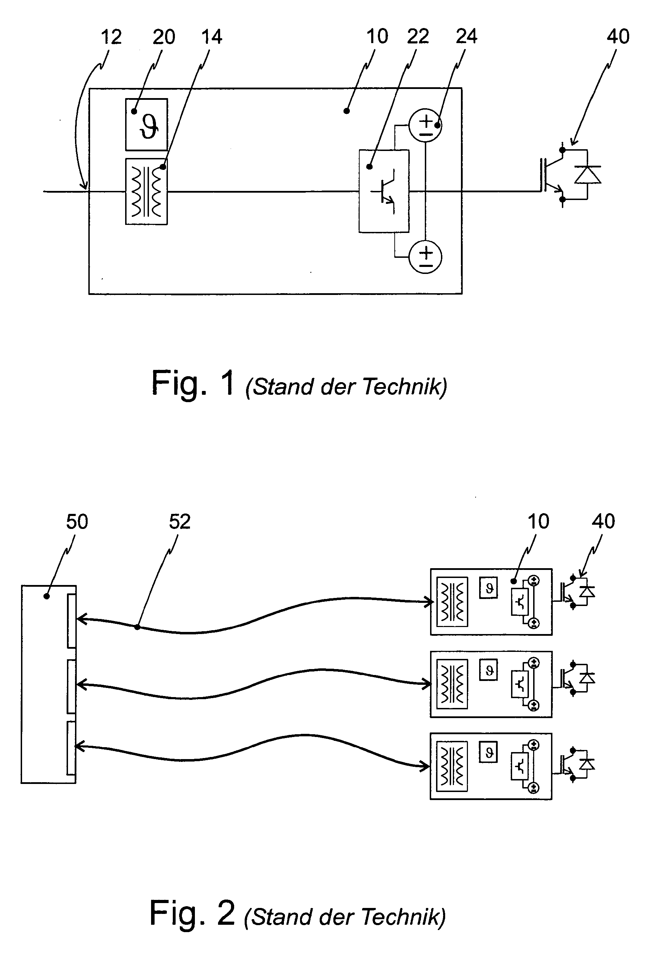

Fig. 1 zeigt eine Treiberschaltungsanordnung (10) für ein Leistungshalbleiterbauelement (40) oder ein Leistungshalbleitermodul nach dem Stand der Technik. Hierbei ist schematisch dargestellt ein Eingang (12) von einer übergeordneten Steuereinheit, der mit einem ersten Trennglied (14), vorzugsweise einem Übertrager mit transformatorischem Wirkprinzip, verbunden ist. Dieser Übertrager (14) trennt das Eingangssignal galvanisch von den übrigen Schaltungsteilen. Die Sekundärseite des Übertragers (14) ist mit einer Ausgangstufe (22) mit zugehöriger Hilfsspannungsversorgung (24), von beispielsweise +15V/-15V bei 50mA Strom, verbunden. Diese Ausgangstufe (22) steuert das zugeordneten Leistungshalbleiterbauelement (40) bzw. was im Folgenden als synonym gelten soll Leistungshalbleitermodul. Dargestellt ist weiterhin die Überwachungs- und Diagnosefunktionalität (20), die nach dem Stand der Technik beispielhaft eine VCE-Überwachung, eine Temperaturüberwachung und eine Hilfsspannungsüberwachung einschließt.

Fig. 2 zeigt eine Schaltungsanordnung bestehend aus einer übergeordneten Steuerung (50) mit einer Mehrzahl von Steuerleitungen (52) zu einzelnen Treiberschaltungsanordnungen (10). Jede dieser einzelnen Treiberschaltungsanordnungen (10) ist ausgebildet gemäß dem Beispiel nach Fig. 1. Beispielhaft können bei einer derartigen Steuerung auch Lichtwellenleiter als Steuerleitung (52) Verwendung finden. Skalierbar ist eine derartig Lösung nach dem Stand der Technik indem die Anzahl der Steuerleitungen (52) erhöht und ebenso die Anzahl der einzelnen Treiberschaltungsanordnungen (10) mit zugeordneten Leistungshalbleitermodulen (40) erhöht wird. Ebenso bekannt ist die serielle Verbindung anstelle der dargestellten parallelen.

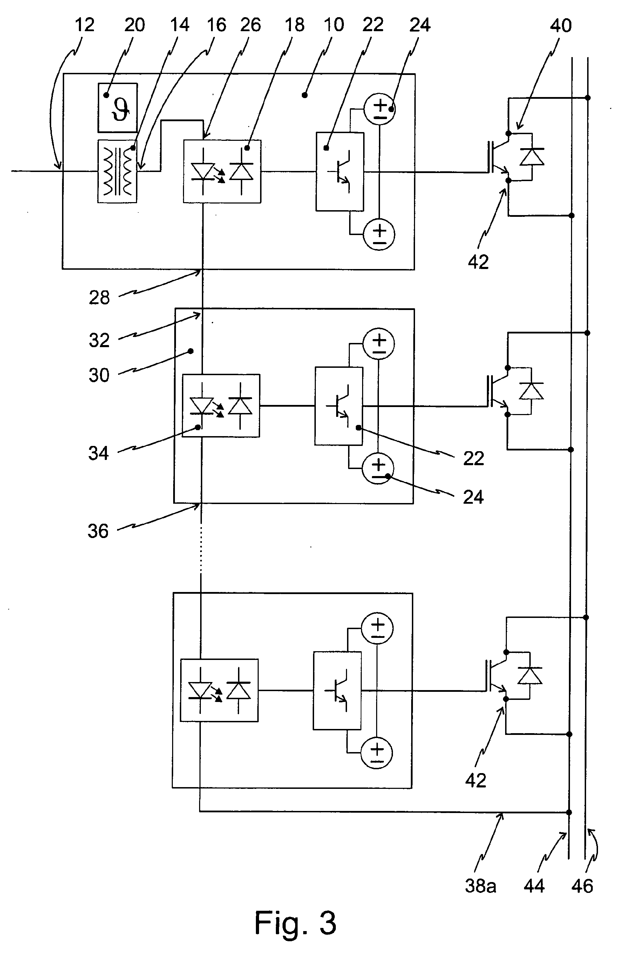

Fig. 3 zeigt eine erste Ausgestaltung der erfindungsgemäßen Treiberschaltungsanordnung. Dargestellt ist eine Master-Slave Konfiguration, wobei der Master (10) alle Funktionsgruppen der unter Fig. 1 dargestellten Treiberschaltungsanordnung aufweist. Darüber hinaus weist der Master mindestens ein weiteres Trennglied (18) auf, wobei dieses weitere Trennglied (18) zwischen dem ersten Trennglied (14) und der Ausgangsstufe (22) geschaltet ist. Die Slaves (30) weisen ihrerseits keinen Eingang von einer übergeordneten Ansteuerung mit zugeordnetem Übertrager auf, sondern ausschließlich ein Trennglied (34) verbunden mit einer Ausgangstufe (22) mit zugehöriger Hilfsspannungsversorgung (24) zur Ansteuerung mindestens eines zugeordneten Leistungshalbleiterbauelements (40). Es kann bevorzugt sein den Slave (30) zusätzlich mit eingeschränkter Überwachungsfunktionalität auszubilden.

Gemäß dieser ersten Ausgestaltung ist der Übertrager (14) des Masters (10) mit einem weiteren Trennglied (18), hier einem Optokoppler, verbunden, dessen Ausgang (28) mit einem Eingang (32) des Optokopplers (34) des ersten Slaves (30) verbunden ist. Im weitern ist die Sekundärseite des Optokopplers (18) mit der Ausgangsstufe (22) verbunden. Dieser zusätzliche Optokoppler (18) ändert somit nichts an der Funktionalität gegenüber einer einzelnen Treiberschaltungsanordnung gemäß Fig. 1. Der Optokoppler (18) erhöht allerdings die Störsicherheit des Masters (10), da er eine galvanische Verbindung zwischen einem defekten Leistungshalbleiterbauelement (40) und der Ansteuereinheit auch im Fehlerfall verhindert.

Jeder Slave (30) der skalierbaren Treiberschaltungsanordnung weist einen Eingang (32) der mit nachgeschalteten einem Trennglied (34), ebenfalls einem Optokoppler, verbunden ist und einen mit dessen Ausgang verbundenen Ausgang (36) auf. Die Sekundärseite des Optokopplers (34) ist wie beim Master (10) mit einer Ausgangsstufe (22) mit Hilfsspannungsversorgung (24) zur Ansteuerung des zugeordneten Leistungshalbleiterbauelements (40) verbunden.

In dieser seriellen Schaltung ist der Optokoppler (34) des ersten Slaves (30) mit dem Ausgang (28) des Optokopplers (18) des Masters (10) verbunden und jeder weitere Slave (30) ist mit seinem Eingang (32) des Optokopplers (34) mit dem Ausgang (36) des Optokopplers (34) des vorgeschalteten Slaves verbunden. Der Ausgang des Optokopplers (34) des in der Reihe letzten Slaves (30) der seriellen Schaltung ist mit dem Emitter (42) des zugeordneten Leistungshalbleiterbauelements (40) verbunden ist. Da es sich um eine skalierbare Anordnung handelt sind die Leistungshalbleiterbauelemente (40) bzw. die Leistungshalbleitermodule parallel miteinander verschalten, wobei die Kollektoren sowie die Emitter jeweils eine gemeinsame Verbindung (44, 46) aufweisen.

Die serielle Master-Slave Schaltung weist den Vorteil auf, dass bei Verwendung identischer Optokoppler (18, 34) auf Grund annährend gleicher, fast identischer, Zeitverzögerung sowohl der Master (10) als auch alle Slaves (30) gleichzeitig die zugeordneten Leistungshalbleiterbauelemente (40) einschalten. Weiterhin kann die serielle Verbindung der Optokoppler (18, 34) als Ausfalldetektion eines Slaves (30) dienen.

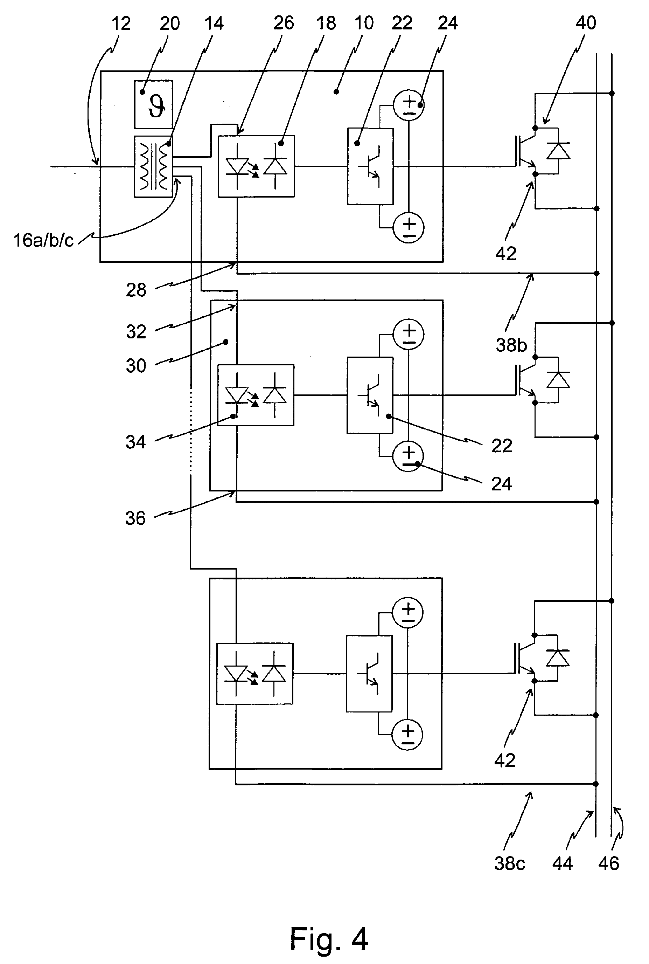

Fig. 4 zeigt eine zweite Ausgestaltung der erfindungsgemäßen Treiberschaltungsanordnung. Hierbei ist die Anordnung der Leistungshalbleiterbauelemente (40) bzw. Leistungshalbleitermodule identisch derjenigen aus Fig. 3. Die Funktionalitäten des Masters (10) und der Slaves (30) ist ebenfalls identisch denjenigen aus Fig. 3. Allerdings ist die Master-Slave Anordnung hier parallel verschaltet.

Hierzu weist der Übertrager (14) eine Mehrzahl von Ausgängen (16 a/b/c) auf mit denen sowohl der Optokoppler (18) des Masters (10) als auch diejenigen (34) der Slaves (30) gleichberechtigt verbunden sind. Die Ausgänge aller Optokoppler (18, 34) sind jeweils mit den Emitter (42) der zugeordneten Leistungshalbleiterbauelemente (40) verbunden.

Die serielle Ausgestaltung der Master-Slave Schaltung weist den Vorteil auf, dass bei redundant ausgelegten Systemen mit einer größeren Anzahl von Leistungshalbleiterbauelementen (40), als sie gemäß der benötigten Leistung erforderlich wären, bei Ausfall eines Leistungshalbleiterbauelements die Funktion des Gesamtsystems vollständig erhalten bleibt. Durch den Einsatz der Optokoppler (18, 34) und der dadurch erreichten galvanischen Trennung wird hierbei eine Rückwirkung des Ausfalls einer Komponente auf andere Komponenten sicher verhindert.

## Patentansprüche

1. Treiberschaltungsanordnung in Master - Slave Konfiguration zur Ansteuerung von leistungselektronischen Schaltungen mit steuerbaren Leistungshalbleiterbauelementen (40),
mit einem Master (10), der mindestens einen Eingang (12) für ein Ansteuersignal von einer übergeordneten Ansteuerung und weiterhin ein erstes Trennglied (14) zur Potentialtrennung zur übergeordneten Ansteuerung aufweist, sowie mindestens eine Ausgangstufe (22) mit zugehöriger Hilfsspannungsversorgung (24) zur Ansteuerung mindestens eines zugeordneten Leistungshalbleiterbauelements (40), eine Mehrzahl von Überwachungsfunktionen (20) und weiterhin mindestens ein weiteres Trennglied (18) aufweist, wobei dieses weitere Trennglied (18) zwischen dem ersten Trennglied (14) und der Ausgangsstufe (22) geschaltet ist
und mit mindestens einem Slave (10), der ein Trennglied (34) verbunden mit einer Ausgangstufe (22) mit zugehöriger Hilfsspannungsversorgung (24) zur Ansteuerung mindestens eines zugeordneten Leistungshalbleiterbauelements (40) aufweist
wobei in einer ersten seriellen Schaltung das Trennglied (34) eines ersten Slave (30) mit einem Ausgang (28) des weiteren Trennglieds (18) des Masters (10) verbunden ist, und der Eingang (32) des Trennglieds (34) eines weiteren Slaves (30) mit dem Ausgang (36) des Trenngliedes (34) des vorgeschalteten Slaves (30) verbunden ist oder
wobei in einer zweiten parallelen Schaltung der Eingang (32) des Trennglieds (34) jedes Slaves (30) direkt mit dem Ausgang (16 a/b/c) des ersten Trennglieds (14) des Master (10) verbunden ist.

2. Treiberschaltungsanordnung nach Anspruch 1
wobei das weitere Trennglied (18) des Masters (10) und die Trennglieder (34) der Slaves (30) als Optokoppler ausgebildet sind.

3. Treiberschaltungsanordnung nach Anspruch 1
wobei in der ersten, seriellen Schaltung der Ausgang (36) des Trennglieds (34) des in der Reihe letzten Slaves (30) mit dem Emitter (42) des zugeordneten Leistungshalbleiterbauelements (40) verbunden ist.

4. Treiberschaltungsanordnung nach Anspruch 1
wobei in der zweiten, parallelen Schaltung der Ausgang (28) des weiteren Trennglieds (18) des Masters (10) und die Ausgänge (36) des jeweiligen Trenngliedes (34) aller Slaves (30) mit dem Emitter (42) des zugeordneten Leistungshalbleiterbauelements (40) verbunden sind.

5. Treiberschaltungsanordnung nach Anspruch 1
wobei der Master (10) Überwachungsfunktionen (20) wie Spannungsüberwachung zwischen Kollektor und Emitter und eine Kurzpulsunterdrückung sowie eine Fehlerübermittlung an die übergeordnete Steuerung aufweist.
